# EUROPEAN PATENT APPLICATION

(11) **EP 3 812 704 A1**
(43) Date of publication of application: **28.04.2021**
(21) Application number: 19819651.1
(22) Date of filing: 12.06.2019
(51) Int. Cl.: G01C 19/5607, H01L 41/113

(54) **SENSOR ELEMENT AND ANGULAR VELOCITY SENSOR**

(30) Priority: 13.06.2018 JP 2018112929
(71) Applicant: Kyocera Corporation, Kyoto-shi, Kyoto 612-8501 (JP)
(72) Inventor: SOEJIMA, Munetaka, Kyoto-shi, Kyoto 612-8501 (JP); TAKANAMI, Shun, Kyoto-shi, Kyoto 612-8501 (JP)
(74) Representative: Viering, Jentschura & Partner mbB Patent- und Rechtsanwälte
(86) International application number: PCT/JP2019/023299
(87) International publication number: WO 2019/240176

(57) **Abstract**

In a piezoelectric body of a sensor element, a pair of driving arms extend alongside each other from a base part to a +y side in a y-direction. A pair of detecting arms extend alongside each other from the base part to a -y side in the y-direction. A holding part extends between the pair of detecting arms from the base part to the -y side and extends out beyond front ends of the pair of detecting arms to the -y side. A mounting part is connected to an end part of the holding part on the -y side and includes a detection side extending portion and two lateral side extending portions. The detection side extending portion extends from a position connected with the holding part to an x-side and -x side. The two lateral side extending portions extend toward the +y side from positions on the +x side and -x side other than both of the two detecting arms. At least one of the plurality of element terminals is located beyond the detection side extending portion on the further +y side.

## Description

### Technical Field

The present disclosure relates to a sensor element and an angular velocity sensor.

### Background Art

As a sensor element of an angular velocity sensor (gyroscope), a piezoelectric vibration type one is known (for example Patent Literatures 1 and 2).

A piezoelectric body of the sensor element of Patent Literature 1 has a base part, a pair of driving arms extending alongside each other from the base part, and a pair of detecting arms extending from the base part to the side opposite to the pair of driving arms. When the sensor element rotates in a state where the driving arms are excited, a Coriolis force is generated and the detecting arms vibrate with amplitudes corresponding to the angular velocity. Due to this, an electrical signal corresponding to the angular velocity is generated in the detecting arms. Further, the piezoelectric body of the sensor element of Patent Literature 1 has a support rod which extends between the pair of detecting arms from the base part alongside the pair of detecting arms and extends out beyond the front ends of the detecting arms toward the side opposite to the base part and a fixed plate which is connected to the end part of the support rod on the opposite side to the base part. The base part is supported by the fixed plate through the support rod.

The piezoelectric body in the sensor element in Patent Literature 2 has a base part, and a driving arm and detecting arm which extend from the base part in the same directions as each other, and a support part which extends out of the base part. The base part is supported by the support part. The support part has a frame surrounding the base part, the driving arm, and the detecting arm (FIG. 11 and FIG. 13). The frame configures a portion of outer walls of a package packaging the base part, the driving arm, and the detecting arm.

### Citation List

### Patent Literature

Patent Literature 1: Japanese Patent Publication No. 10-54725
Patent Literature 2: Japanese Patent Publication No. 2015-149591

### Summary of Invention

A sensor element according to one aspect of the present disclosure includes a piezoelectric body, a plurality of first electrodes and a plurality of second electrodes, and a plurality of terminals each connected to any of the plurality of first electrodes and the plurality of second electrodes. The piezoelectric body, when viewed in a z-direction in an orthogonal coordinate system xyz, includes a base part, two first arms, two second arms, a holding part, and a mounting part. The two first arms extend alongside each other from the base part toward one side in a y-direction. The plurality of first electrodes are located on the two first arms. The two second arms extend alongside each other from the base part toward the other side in the y-direction. The plurality of second electrodes are located on the two second arms. The holding part extends between the two second arms from the base part toward the other side in the y-direction and extends out beyond front ends of the two second arms toward the other side in the y-direction. The mounting part is connected to an end part of the holding part on the other side in the y-direction. In the mounting part, the plurality of terminals are located. The mounting part includes a first extending portion which extends from a position connected with the holding part toward an x-side and -x side, and two second extending portions which extend from positions in the first extending portion which are beyond both of the two second arms on the further +x side and -x side toward the one side in the y-direction. At least one of the plurality of terminals is located beyond the first extending portion on the one side in the y-direction.

An angular velocity sensor according to one aspect of the present disclosure includes a sensor element including a piezoelectric body, and a mounting body on which the sensor element is mounted. The piezoelectric body, when viewed in a z-direction in an orthogonal coordinate system xyz, includes a base part, two first arms, two second arms, a holding part, and a mounting part. The two first arms extend alongside each other from the base part toward one side in a y-direction. The two second arms extend alongside each other from the base part toward the other side in the y-direction. The holding part extends between the two second arms from the base part toward the other side in the y-direction and extends out beyond front ends of the two second arms toward the other side in the y-direction. The mounting part is connected to an end part of the holding part on the other side in the y-direction and is fixed to the mounting body at a plurality of fixation positions. The mounting part includes a first extending portion which extends from a position connected with the holding part toward a +x side and -x side, and two second extending portions which extend from positions in the first extending portion which are beyond both of the two second arms on the +x side and -x side toward the one side in the y-direction. At least one of the plurality of fixation positions is located beyond the first extending portion on the one side in the y-direction.

### Brief Description of Drawings

FIG. 1 is a disassembled perspective view showing a schematic configuration of an angular velocity sensor according to a first embodiment.
FIG. 2A is a cross-sectional view taken along the IIa-IIa line in FIG. 1, and FIG. 2B is a cross-sectional view taken along the IIb-IIb line in FIG. 1.
FIG. 3 is a perspective view showing the configuration of a principal part of a sensor element in the angular velocity sensor in FIG. 1.
FIG. 4 is a plan view showing the configuration of the principal part of the sensor element in FIG. 4.
FIG. 5A is a cross-sectional view taken along the Va-Va line in FIG. 4, and FIG. 5B is a cross-sectional view taken along the Vb-Vb line in FIG. 4.
FIG. 6 is a plan view showing a sensor element according to a second embodiment.
FIG. 7 is a plan view showing a sensor element according to a third embodiment.
FIG. 8 is a plan view showing a sensor element according to a fourth embodiment.
FIG. 9 is a plan view showing a sensor element according to a fifth embodiment.

### Description of Embodiments

Below, embodiments of the present disclosure will be explained with reference to the drawings. The drawings used in the following explanation are schematic ones. Ratios among various dimensions in the drawings do not always coincide with the actual ones. Further, among the plurality of drawings, ratios among various dimensions do not always coincide with each other. For convenience, sometimes hatching will be attached to the surfaces of layered members (that is the surfaces which are not cross-sections).

Further, to each of the drawings, for convenience of explanation, an orthogonal coordinate system xyz is attached. The orthogonal coordinate system xyz is defined based on the shape of the sensor element (piezoelectric body). That is, an x-axis, y-axis, and z-axis do not always indicate the electrical axis, mechanical axis, and optical axis of a crystal. In the angular velocity sensor and sensor element, any direction may be used as the "above" or "below". In the following explanation, however, for convenience, sometimes the "upper surface" or "lower surface" and other terms will be used where the positive side of the z-direction is the upper part. Further, when simply referred to as "viewed on a plane", it means "viewed in the z-direction" unless particularly explained otherwise.

For the same or similar configurations, sometimes numbers which are different from each other ("first", "second") and/or additional notations of alphabetic letters which are different from each other ("A" and "B") will be attached such as with the "first driving arm 23A" and "second driving arm 23B". Further, in this case, sometimes the configurations will be simply referred to as the "driving arms 23" and will not be differentiated.

In the second and following embodiments, for configurations which are common or similar to the configurations in the already explained embodiments, the notations which were attached to the configurations in the already explained embodiments will be used. Further, sometimes illustration or explanations will be omitted. For the configurations corresponding to (similar to) the configurations in the already explained embodiments, even in a case where notations which are different from those for the configurations in the already explained embodiments are attached, they may be the same configurations as those in the already explained embodiments unless particularly explained otherwise. That is, in the second and following embodiments, basically only the portions which are different from those in the already explained embodiments will be explained.

### [First Embodiment]

### (Overall Configuration of Angular Velocity Sensor)

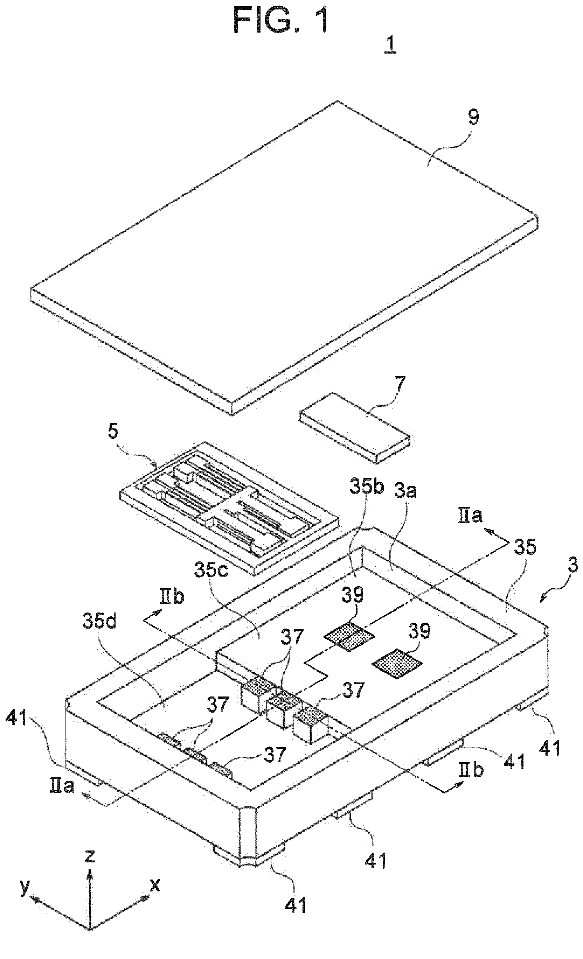

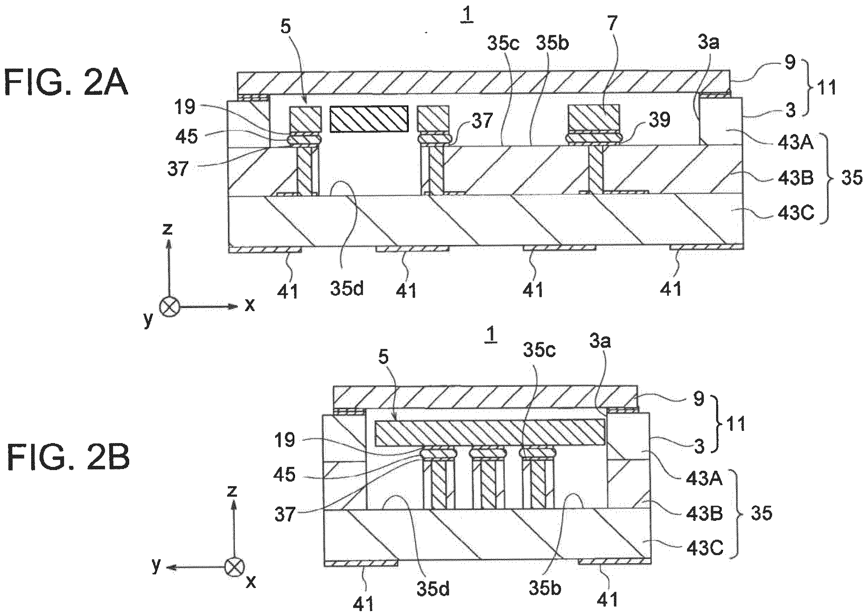

FIG. 1 is a disassembled perspective view showing a schematic configuration of an angular velocity sensor 1 (hereinafter, sometimes the "angular velocity" will be omitted) according to an embodiment of the present disclosure. FIG. 2A is a cross-sectional view of the sensor 1 taken along the IIa-IIa line in FIG. 1. FIG. 2B is a cross-sectional view of the sensor 1 taken along the IIb-IIb line in FIG. 1.

In the present embodiment, the sensor 1 is configured so as to detect the angular velocity about the y-axis. The sensor 1, for example, as a whole, is a schematically thin cuboid shaped electronic part. The dimensions thereof may be suitably set. If giving one example of dimensions according to a relatively small-sized aspect, the length of one side when viewed on a plane is 1 mm to 10 mm, and the thickness (z-direction) is 0.5 mm to 2 mm (however, smaller than the length of a short side when viewed on a plane).

The sensor 1 for example has a mounting body 3 having a recessed part 3a formed therein, a sensor element 5 and electronic element 7 which are accommodated in the recessed part 3a, and a lid 9 closing the recessed part 3a. The sensor element 5 is the portion which is directly responsible for detection of the angular velocity. The electronic element 7 is for example an electronic part contributing to multiple functionalization of the sensor 1. The mounting body 3 and lid 9 configure a package 11 packaging the sensor element 5 (and electronic element 7).

### (Overall Configuration of Sensor Element)

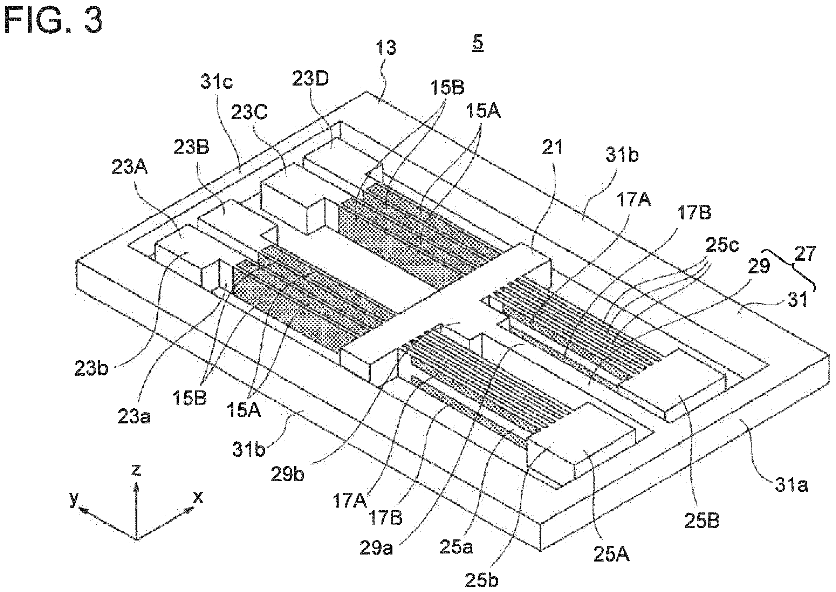

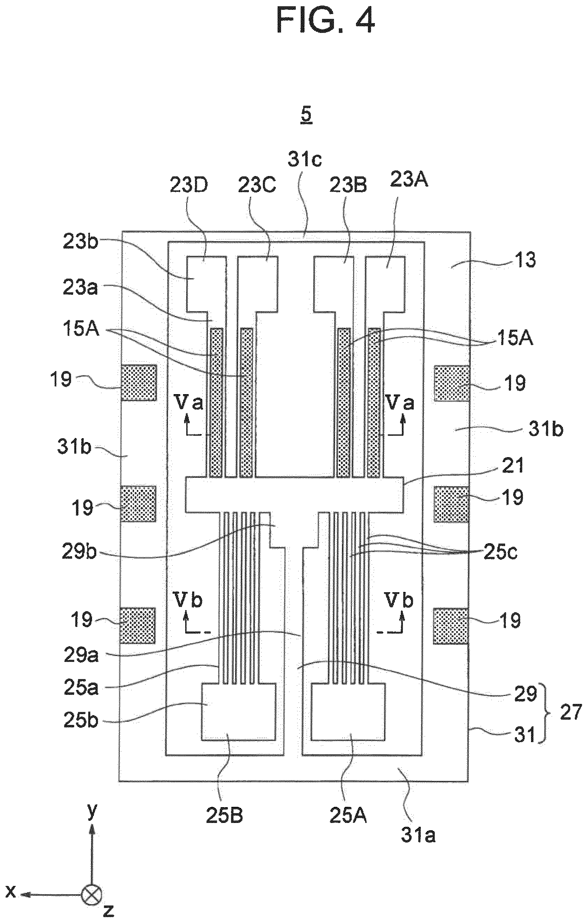

FIG. 3 is a perspective view showing the configuration of the principal part of the sensor element 5. FIG. 4 is a plan view (bottom surface view) showing the configuration of the principal part of the sensor element 5. As will be understood from the direction of the z-axis, among the upper surface and the lower surface of the sensor element 5, FIG. 4 shows the lower surface (side fixed to the mounting body 3).

The sensor element 5 is a piezoelectric vibration type one. When used, the sensor element 5 is excited in the x-direction by utilizing an inverse piezoelectric effect. When the sensor element 5 rotates about the y-axis in this state, a Coriolis force in the z-direction is generated, so the sensor element 5 vibrates in the z-direction with an amplitude corresponding to the angular velocity. By conversion of this vibration to an electrical signal by the piezoelectric effect, the angular velocity is detected.

The sensor element 5 according to the present embodiment may be the same as the sensor element described in Japanese Patent Publication No. 2015-141184 except for the configuration relating to a support part 27 which will be explained later. Accordingly, the content of this publication may be incorporated by reference. Further, in the explanation of the sensor element 5, sometimes explanation of details will be omitted for configurations other than the support part 27.

The sensor element 5 has a piezoelectric body 13, first excitation electrodes 15A and second excitation electrodes 15B (FIG. 3) for supplying voltages to the piezoelectric body 13, first detecting electrodes 17A (FIG. 3) and second detecting electrodes 17B (FIG. 3) for extracting electrical signals generated in the piezoelectric body 13, and element terminals 19 (FIG. 4) for mounting the sensor element 5 on the mounting body 3.

Additional notations "A" and "B" of the excitation electrodes 15 and detecting electrodes 17 are attached based on the orthogonal coordinate system xyz. Accordingly, as will be explained later, one first excitation electrode 15A and another first excitation electrode 15A do not always have the same potential. The same is true for the second excitation electrodes 15B, first detecting electrodes 17A, and second detecting electrodes 17B.

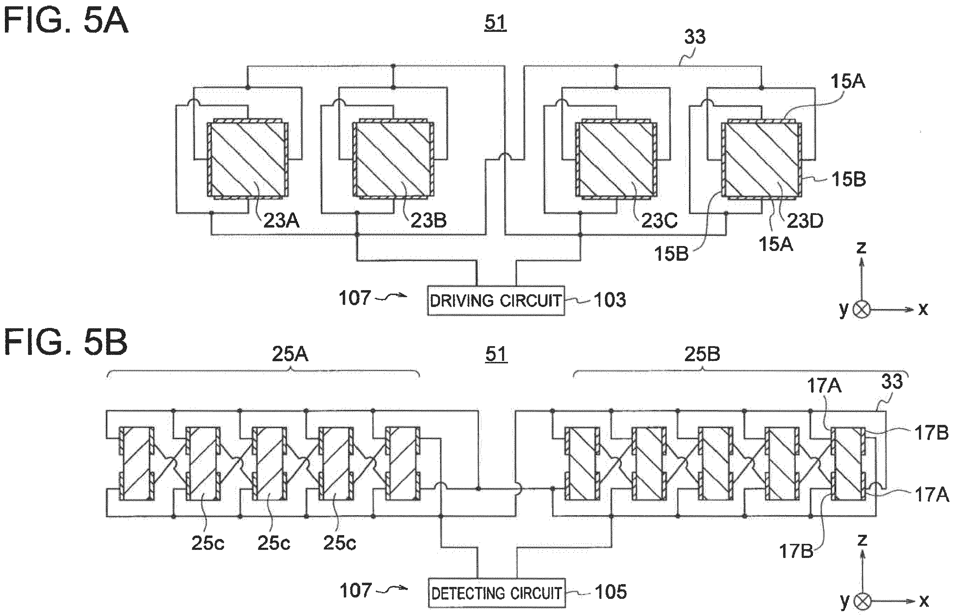

The excitation electrodes 15, detecting electrodes 17, element terminals 19, and wirings 33 (schematically shown in FIG. 5A and FIG. 5B) connecting them are configured by conductor layers provided on the surface of the piezoelectric body 13. The material for those is for example Cu, Al, or another suitable metal. These conductor layers may be configured by layers made of mutually different materials which are stacked on each other as well.

### (Piezoelectric Body)

The piezoelectric body 13 is integrally formed as a whole. The piezoelectric body 13 may be a single crystal or may be a polycrystal. Further, the material of the piezoelectric body 13 may be suitably selected. It is for example quartz crystal (SiO2), LiTa03, LiNbO3, or PZT.

In the piezoelectric body 13, the electrical axis or polarization axis (below, sometimes only the polarization axis will be referred to as representative of the two) is set so as to coincide with the x-axis. The polarization axis may be inclined relative to the x-axis within a predetermined range (for example 15° or less) as well. Further, in a case where the piezoelectric body 13 is a single crystal, the mechanical axis and optical axis may be made suitable directions. For example, the mechanical axis is made substantially parallel to the y-axis and the optical axis is made substantially parallel to the z-axis.

The piezoelectric body 13 is for example made substantially constant in thickness (z-direction) as a whole. Further, the piezoelectric body 13 is for example formed substantially in a line symmetrical shape relative to a not shown symmetrical axis parallel to the y-axis. Further, the piezoelectric body 13 for example includes a base part 21, driving arms 23 (first driving arm 23A to fourth driving arm 23D) and detecting arms 25 (first detecting arm 25A and second detecting arm 25B) which extend out of the base part 21, and a support part 27 which is connected with the base part 21.

The two (for example pair of) driving arms 23 are excited in the x-direction by application of voltage (electric field). The detecting arms 25 vibrate in the z-direction due to the Coriolis force and generate electrical signals corresponding to the angular velocity. The base part 21 for example contributes to support of the driving arms 23 and detecting arms 25 and transfer of vibration from the driving arms 23 to the detecting arms 25. The support part 27 for example contributes to support of the base part 21 and mounting of the sensor element 5 onto the mounting body 3. The specific configurations of these are for example as follows.

### (Base Part, Driving Arms, and Detecting Arms)

The base part 21 is for example formed in a substantially cuboid shape so as to linearly extend in the x-direction with a constant width.

The pluralities of driving arms 23 extend alongside (for example in parallel to) each other in the same directions (to the +y side) as each other. The front ends of them are made free ends. The number of the driving arms 23 is for example an even number (four in the present embodiment).

The shape of each of the driving arms 23 when viewed on a plane is for example a so-called hammer shape. That is, the driving arm 23 has a body portion 23a which extends from the base part 21 to the +y side with a constant width and a broad width portion 23b which is positioned at the front end of the body portion 23a and is broader in width (x-direction) than the body portion 23a. Due to this, the mass of the driving arm 23 is secured at the front end. In turn, it becomes possible to improve the sensitivity while reducing the size.

More specifically, in the inner side driving arms 23 (second driving arm 23B and third driving arm 23C) among the four driving arms 23, the broad width portions 23b for example spread to the inner side relative to the body portions 23a. In the outer side driving arms 23 (first driving arm 23A and fourth driving arm 23D) among the four driving arms 23, the broad width portions 23b for example spread to the outer sides relative to the body portions 23a.

Regarding the distance between the pair of driving arms 23 (second driving arm 23B and third driving arm 23C) which are positioned on the two sides of a not shown center line of the piezoelectric 13 and closest with respect to the center line, due to provision of the broad width portions 23b as described above, the distance at the side of the front ends (lateral sides of the broad width portions 23b) becomes shorter than the distance at the side of the roots (lateral sides of the body portions 23a).

Unlike the example shown, in each of the driving arms 23, the broad width portion 23b may spread to both sides relative to the body portion 23a as well. Further, in each of the driving arms 23, the broad width portion 23b need not be provided either.

When the driving arms 23 become larger in the x-direction (excitation direction) or z-direction (direction of the Coriolis force), the natural frequencies in the x-direction or z-direction of the driving arms 23 become higher. When the driving arms 23 become larger in the extension direction (y-direction), the natural frequencies in the x-direction or z-direction of the driving arms 23 become lower. Accordingly, for example, the ratios of the dimensions of the widths (x-direction) and lengths (y-direction) of the driving arms 23 may be set so that the natural frequencies in the excitation direction (x-direction) of the driving arms 23 become closer to the frequency of exciting the driving arms 23. Further, the shapes and dimensions of the xz cross-sections of the driving arms 23 may be for example set so that the natural frequencies in the x-direction of the driving arms 23 and the natural frequencies in the z-direction thereof become closer.

The plurality of detecting arms 25 extend alongside (for example in parallel to) each other to an opposite direction (-y side) to the direction in which the pluralities of driving arms 23 extend. The front ends of the plurality of detecting arms 25 are formed as free ends. The number of the detecting arms 25 is for example an even number (two in the present embodiment).

The shape of each detecting arm 25 when viewed on a plane is for example made a hammer shape in the same way as the driving arms 23. That is, the detecting arm 25 has a body portion 25a which extends from the base part 21 to the -y side with a constant width and a broad width portion 25b which is positioned at the front end of the body portion 25a and is broader in width (x-direction) than the body portion 25a. Due to this, the mass of the detecting arm 25 is secured at the front end. In turn, it becomes possible to improve the sensitivity while reducing the size.

More specifically, the broad width portion 25b for example spreads to the both sides in the x-direction relative to the body portion 25a. Due to this, regarding the distance between two (for example a pair of) detecting arms 25, the distance at the side of the front ends (lateral sides of the broad width portions 25b) becomes shorter than the distance at the side of the roots (lateral sides of the body portions 25a). Unlike the example shown, the broad width portion 25b may spread to only one side in the x-direction (for example outer side of the pair of detecting arms 25) relative to the body portion 25a as well. Further, the broad width portion 25b need not be provided either.

Each detecting arm 25 (for example the body portion 25a in each detecting arm 25) is for example shaped formed with one or a plurality of (four in the example shown) slits (notation omitted) which penetrate through the detecting arm 25 in the z-direction and extend in the y-direction. From another viewpoint, each detecting arm 25 has a plurality of (five in the example shown) divided arms 25c which extend alongside each other. By the detecting arm 25 having the plurality of divided arms 25c, for example, as will be understood from the explanation given later, the number of detecting electrodes 17 arranged is increased and detection sensitivity can be improved.

When the detecting arms 25 become large in the x-direction (excitation direction) or z-direction (direction of the Coriolis force), the natural frequencies in the x-direction or z-direction of the detecting arms 25 become higher. When the detecting arms 25 become large in the extension direction (y-direction), the natural frequencies in the x-direction and z-direction of the detecting arms 25 become lower. Accordingly, for example, the ratios of the dimensions of the thicknesses (z-direction) and lengths (y-direction) of the detecting arms 25 may be set to that the natural frequencies in the z-direction of the detecting arms 25 become closer to the frequency of exciting the driving arms 23. Further, for example, the ratios of the dimensions of the widths (x-direction) and lengths(y-direction) of the detecting arms 25 may be set so that the natural frequencies in the x-direction of the detecting arms 25 are separated from the frequency of exciting the driving arm 23. In the example shown, as a result of setting as described above, the width of the detecting arm 25 is made larger than the width of the driving arm 23 and the thickness of the detecting arm 25 (driving arm 23).

### (Support Part)

The support part 27 for example has a holding part 29 which extends from the base part 21 and a mounting part 31 which is connected to the end part of the holding part 29 on the opposite side to the base part 21. By the mounting part 31 being fixed to the mounting body 3, the base part 21 is supported upon the mounting body 3 through the mounting part 31 and holding part 29. The base part 21 is not supported at its two ends upon the mounting part 31, but is supported through the holding part 29 upon the mounting part 31. Therefore, for example, even if stress is generated in the mounting part 31 due to a difference of thermal expansion between the mounting part 31 and the mounting body 3, the stress is not easily transferred to the base part 21.

The holding part 29 for example extends between the pair of detecting arms 25 from the base part 21 to the -y side alongside (for example in parallel to) the detecting arms 25. The holding part 29 is longer than the detecting arms 25 and extends out beyond the front ends of the detecting arms 25 to the -y side.

The holding part 29 for example, in the example shown, has a main portion 29a configuring most of the holding part 29 and a connection portion 29b connecting the main portion 29a and the base part 21. The width (x-direction) of the connection portion 29b is made broader than the main portion 29a. Due to this, the strength at the position of connection of the holding part 29 and the base part 21 is improved.

The main portion 29a, for example, when viewed on a plane, has schematically a long shape so as to linearly extend from the mounting part 31 to the base part 21 with a constant width (x-direction). In other words, the main portion 29a extends from a portion between the front ends of the pair of detecting arms 25 up to the connection portion 29b while maintaining a width not less than about the same width as that of the portion positioned between the front ends (broad width portions 25b) of the pair of detecting arm 25. That is, the main portion 29a (holding part 29) does not have a portion (constriction) which becomes narrower in width on the base part 21 side. The shape of the transverse plane (xz cross-section) of the main portion 29a is for example rectangular.

The connection portion 29b for example has a portion which extends in the y-direction with a constant width broader than the width of the main portion 29a. That is, the connection portion 29b has a rectangular portion when viewed on a plane. The rectangle may be a square or an oblong which is longer in any of the x-direction and y-direction. The shape of the transverse plane (xz cross-section) of the connection portion 29b is for example rectangular.

The dimensions of the main portion 29a and connection portion 29b may be suitably set. For example, the widths of these may be made the largest sizes as long as the holding part 29 and the pair of detecting arms 25 do not abut against each other due to vibration for detecting the angular velocity or other reasons. Specifically, for example, the width of the holding part 29 may be set to a length obtained by subtracting displacements in the x-direction of the pair of detecting arms 25 envisioned when they are normally used and a predetermined margin from the distance between the pair of detecting arms 25. At this time, it may be considered that the distance between the pair of detecting arms 25 and/or the displacements of the pair of detecting arms 25 differ according to the position of the main portion 29a and the position of the connection portion 29b in the y-direction.

Specifically, the width of the main portion 29a is less than 1 time the distance between the front ends (broad width portions 25b) of the pair of detecting arms 25. Further, for example, the width of the main portion 29a may be made 1/3 or more or 2/5 or more of the distance between the front ends of the pair of detecting arms 25. Further, the width of the connection portion 29b may be less than 1 time the distance between the root side portions (body portions 25a) of the pair of detecting arms 25. For example, the width of the connection portion 29b may be made less than 1 time or 1 or more times the distance between the front ends of the pair of detecting arms 25. For example, the width of the connection portion 29b may be set to 1.1 times or more the distance between the front ends of the pair of detecting arms 25. Further, the width of the connection portion 29b and the width of the main portion 29a may be suitably set from the viewpoint of the relative sizes of the two. For example, the width of the connection portion 29b may be made 1.1 times to 2 times the width of the main portion 29a.

As explained above, the thickness (z-direction) of the piezoelectric body 13 is basically constant over the piezoelectric body 13 as a whole. The thicknesses of the main portion 29a and the connection portion 29b are the same as each other.

The mounting part 31 is for example formed in a frame shape extending at the peripheries of the base part 21, driving arms 23, and detecting arms 25. In the present embodiment, the frame is an annular shape surrounding the base part 21, driving arms 23, and detecting arms 25. The annular shape is for example substantially rectangular. The mounting part 31 has a detection side extending portion 31a which extends in the x-direction (for example in parallel to the x-direction) on the detecting arm 25 side (-y side), two (for example a pair of) lateral side extending portions 31b which extend in the y-direction (for example in parallel to the y-direction) and face each other in the x-direction, and a driving side extending portion 31c which extends in the x-direction (for example in parallel to the x-direction) on the driving arm 23 side (+y side) . The four corners of the rectangle may be grasped as the end parts of the detection side extending portion 31a or the driving side extending portion 31c or may be grasped as the end parts of the pair of lateral side extending portions 31b. The holding part 29 connects the base part 21 and the detection side extending portion 31a.

The size of the mounting part 31 (lengths etc. of the long sides and short sides) may be suitably set. For example, the mounting part 31 may be separated from the driving arms 23 and detecting arms 25 by suitable distances so as not to abut against these arms due to vibration for detecting the angular velocity or other reasons while being made as small as possible. The lateral side extending portions 31b are for example longer than the detection side extending portion 31a and driving side extending portion 31c. However, the lengths of the two may be made equal and the relative lengths may be reversed from the example shown.

The shape of the transverse plane of the mounting part 31 (each extending portion) is for example substantially rectangular over the whole length of the mounting part 31. The thickness (z-direction) of the mounting part 31 is for example constant over the whole length of the mounting part 31. The width of the mounting part 31 is for example constant in each extending portion (each side) . Further, in the example shown, the widths of the lateral side extending portions 31b become larger than the width of the detection side extending portion 31a, and the width of the detection side extending portion 31a becomes larger than the driving side extending portion 31c. However, the width may change in each extending portion and/or the relative sizes of the widths of the sides may be made different from those described above.

### (Element Terminals)

The number of the element terminals 19 may be suitably set in accordance with the configuration of the sensor element 5. In the present embodiment, a case where provision is made of six element terminals 19 in total, i.e., two element terminals 19 receiving as input driving signals which are supplied to the excitation electrodes 15, two element terminals 19 which output the detection signals from the detecting electrodes 17, and two element terminals 19 given the reference potential, is illustrated.

The two element terminals 19 for the reference potential, for example, although not particularly shown, are connected at the base part 21 etc. to a shield-use wiring which is arranged between a driving signal-use wiring 33 and a detection signal-use wiring 33. Such element terminals 19 and wiring for reference potential use may be omitted as well. Further, the wiring for the reference potential use in the base part 21 may be made the same as that disclosed in Japanese Patent Publication No. 2015-141183. The content of this publication may be incorporated by reference.

The element terminals 19 are for example provided on the lower surface (surface on the -z side) of the mounting part 31. The positions, shapes, and sizes of the plurality of element terminals 19 when viewed on a plane may be suitably set. In the example shown, the six element terminals 19 are arranged separated from the four corners of the mounting part 31 in the pair of lateral side extending portions 31b. In other words, all element terminals 19 are positioned closer to the +y side than the detection side extending portion 31a and closer to the -y side than the driving side extending portion 31c. In more detail, for example, all element terminals 19 are positioned between the front ends of the driving arms 23 and the front ends of the detecting arms 25 in the y-direction. Further, the plurality of element terminals 19 are for example schematically arranged line symmetrical relative to a symmetrical axis parallel to the x-axis and a symmetrical axis parallel to the y-axis which pass through the center of gravity of the sensor element 5. Each element terminal 19 is for example formed in a rectangular shape so as to have a width about the same as the widths of the lateral side extending portions 31b or a width somewhat smaller than the latter.

### (Excitation Electrodes)

FIG. 5A is a cross-sectional view taken along the Va-Va line in FIG. 4. As understood from the direction of the x-axis, between FIG. 4 and FIG. 5A, the relationships of positive/negative of the x-axis and left/right directions on the drawing sheet are inverse.

The excitation electrodes 15 (notation is attached to the fourth driving arm 23D on the right side on the drawing sheet) are layered conductors which are formed on the surfaces of the driving arms 23. A first excitation electrode 15A, in each of the driving arms 23, is provided on each of the upper surface and lower surface (surface on the +z side and surface on the -z side) . On the other hand, a second excitation electrode 15B, in each of the driving arm 23, is provided on each of the side surfaces (surface on the +x side and surface on the -x side).

Each excitation electrode 15 is for example provided so as to cover most of each surface of the body portion 23a in the driving arm 23 (see FIG. 3 and FIG. 4 as well) . However, at least one of the first excitation electrode 15A and the second excitation electrode 15B (first excitation electrode 15A in the present embodiment) is formed smaller in the width direction than each surface so that these excitation electrodes do not short-circuit with each other. Further, portions on the root side and front end side of the body portions 23a may be made positions where the excitation electrodes 15 are not arranged.

In each of the driving arms 23, the two first excitation electrodes 15A are for example rendered the same potentials as each other. For example, the two first excitation electrodes 15A are connected to each other by a wiring 33 on the piezoelectric body 13. Further, in each of the driving arms 23, the two second excitation electrodes 15B are for example rendered the same potentials as each other. For example, the two second excitation electrodes 15B are connected to each other by a wirings 33 on the piezoelectric body 13.

In such an arrangement and connection relationships of the excitation electrodes 15, if voltage is supplied between the first excitation electrodes 15A and the second excitation electrodes 15B, for example, in the driving arms 23, an electric field going from the upper surface toward the pair of side surfaces (both sides in the x-direction) and an electric field going from the lower surface toward the pair of side surfaces are generated. On the other hand, the polarization axis matches with the x-direction. Accordingly, when focusing on the components in the x-direction of the electric fields, in the driving arm 23, the orientation of the electric field and the orientation of the polarization axis match in one side portion of the x-direction, while the orientation of the electric field and the orientation of the polarization axis become inverse to each other in the other side portion.

As a result, single side portions of the driving arms 23 in the x-direction contract in the y-direction, and the other side portions extend in the y-direction. Further, the driving arms 23 flex to one side in the x-direction like a bimetal. If voltages supplied to the first excitation electrodes 15A and second excitation electrodes 15B are inverted, the driving arms 23 flex to inverse directions. If an AC voltage is supplied to the first excitation electrodes 15A and the second excitation electrodes 15B, the driving arms 23 vibrate in the x-direction.

Although not particularly shown, one or more recessed grooves extending along the long directions of the driving arms 23 may be provided in the upper surfaces and/or lower surfaces of the driving arms 23, and the first excitation electrodes 15A may be provided over the interiors of the recessed grooves. In this case, the first excitation electrodes 15A and the second excitation electrodes 15B face each other in the x-axis direction while sandwiching the wall portions of the recessed grooves therebetween, therefore the efficiency of excitation is improved. A recessed groove may be configured by a plurality of recessed portions arranged in the long direction of the driving arm 23 as well.

Between two of the driving arms 23 which are adjacent to each other (two of the first driving arm 23A and second driving arm 23B or two of the third driving arm 23C and fourth driving arm 23D), the first excitation electrodes 15A are given the same potentials as each other, and the second excitation electrodes 15B are given the same potentials as each other. The excitation electrodes 15 which should be rendered the same potentials are for example connected to each other by the wirings 33 on the piezoelectric body 13.

In such connection relationships, if applying AC voltage between the first excitation electrodes 15A and the second excitation electrodes 15B, voltages having the same phases as each other are supplied to the two driving arms 23 which are adjacent to each other, therefore the driving arms vibrate so as to flexurally deform to the same orientations as each other in the x-direction. The two driving arms 23 which are adjacent to each other may be grasped as corresponding to ones divided from one driving arm. Although not particularly shown, the two driving arms 23 which are adjacent to each other may be integrally formed to become one at their root portions as well.

Between the pair of driving arms 23 which are line symmetrically arranged (a pair configured by the first driving arm 23A and fourth driving arm 23D or a pair configured by the second driving arm 23B and third driving arm 23C), the first excitation electrodes 15A and the second excitation electrodes 15B are rendered the same potentials. The excitation electrodes 15 which must be rendered the same potentials as each other are for example connected with each other by the wirings 33 on the piezoelectric body 13.

In such connection relationships, if applying AC voltage between the first excitation electrodes 15A and the second excitation electrodes 15B, the pair of driving arms 23 which are line symmetrically arranged are supplied with voltages having inverse phases to each other, therefore they vibrate so as to flexurally deform in inverse orientations from each other (line symmetrically) in the x-direction.

### (Detecting Electrodes)

FIG. 5B is a cross-sectional view taken along the Vb-Vb line in FIG. 4. As understood from the direction of the x-axis, between FIG. 4 and FIG. 5B, the relationships of positive/negative of the x-axis and left/right directions on the drawing sheet are inverse.

The detecting electrodes 17 (notation is attached to the divided arms 25c on the right side on the drawing sheet) are layered conductors which are formed on the surfaces of the detecting arms 25 (divided arms 25c). The detecting electrodes 17 are provided on each divided arm 25c.

More specifically, the first detecting electrodes 17A, on each divided arm 25c, are respectively provided in a region on the +z side in a surface on the -x side (for example the side closer to +z than the center of the surface, the same is true for the following explanation) and a region on the -z side in a surface on the +x side. The second detecting electrodes 17B, on each divided arm 25c, are respectively provided in a region on -z side in the surface on the -x side and in a region on the +z side in the surface on the +x side.

On each side surface of the divided arm 25c, the first detecting electrode 17A and the second detecting electrode 17B extend along the divided arm 25c at a suitable interval so as not to short-circuit with each other. The detecting electrodes 17 extend over substantially the whole length of the divided arm 25c. In each divided arm 25c, the two first detecting electrodes 17A are connected with each other, and the two second detecting electrodes 17B are connected with each other. The connections are for example made by the wirings 33 on the piezoelectric body 13.

In such an arrangement and connection relationships of the detecting electrodes 17, if the divided arms 25c flexurally deform in the z-axis direction, for example, an electric field parallel to the z-axis direction is generated. That is, on each side surface of the divided arms 25c, voltage is generated between the detecting electrode 17A and the detecting electrode 17B. The orientation of the electric field is determined by the orientation of the polarization axes and the orientation of the flex (-z side or +z side). The orientations of the electric fields are inverse to each other between the -x side and the +x side of the divided arms 25c. These voltages (electric fields) are output to the first detecting electrodes 17A and second detecting electrodes 17B. When the divided arms 25c vibrate in the z-direction, the voltages are detected as AC voltage. Among electric fields, the electric fields parallel to the z-direction as described above may be dominant or a ratio of electric fields which are parallel to the x-direction and have inverse orientations to each other between the -z side and the +z side of the divided arms 25c may be larger unlike the above. In any case, voltages in accordance with the flexural deformation of the divided arms 25c in the z-axis direction are generated between the first detecting electrodes 17A and the second detecting electrodes 17B.

Among the plurality of divided arms 25c in each detecting arm 25, the first detecting electrodes 17A are connected with each other and the second detecting electrodes 17B are connected with each other. The connections are for example made by the wirings 33 on the piezoelectric body 13. In such connection relationships, if the plurality of divided arms 25c flexurally deform so as to bend to the same sides as each other in the z-direction, signals detected in the plurality of divided arms 25c are added.

Between the two detecting arms 25, the first detecting electrodes 17A and the second detecting electrodes 17B are connected. The connections are for example made by the wirings 33 on the piezoelectric body 13. In such connection relationships, if the two detecting arms 25 flexurally deform so as to bend to inverse sides to each other in the z-direction, the signals detected in the two detecting arms 25 are added.

### (Wirings)

The plurality of wirings 33 connect the excitation electrodes 15 and the detecting electrodes 17 as explained above. Further, the plurality of wirings 33 connect four sets of electrodes in total, comprised of the excitation electrodes 15 which are divided into two sets from a viewpoint of potentials and the detecting electrodes 17 divided into two sets from a viewpoint of potentials, to the four element terminals 19 (FIG. 4) respectively.

Although not particularly shown, by suitable arrangement of the plurality of wirings 33 on the upper surfaces, lower surfaces, and/or side surfaces of various parts in the piezoelectric body 13, the connections explained above can be realized without short-circuiting with each other in a mode where the entireties of wirings 33 are provided on the surfaces of the piezoelectric body 13. However, three-dimensional interconnect portions may be formed by providing an insulation layer on the wirings 33 positioned on the piezoelectric body 13 and providing the other wirings 33 above the same.

### (Driving Circuit and Detecting Circuit)

As shown in FIG. 5A and FIG. 5B, a driving circuit 103 supplying voltages to the excitation electrodes 15 is connected to the excitation electrodes 15 through two element terminals 19 not shown here. Further, a detecting circuit 105 detecting the electrical signals from the detecting electrodes 17 is connected to the detecting electrodes 17 through two element terminals 19 not shown here.

The combination of the sensor element 5 (or angular velocity sensor 1) and the driving circuit 103 and detecting circuit 105 may be considered to configure the angular velocity sensor 51. The driving circuit 103 and detecting circuit 105 configure a control circuit 107 as a whole. The control circuit 107 is for example configured by an IC (integrated circuit). Such an IC may be mounted on the mounting body 3 to be packaged together with the sensor element 5 or may be mounted on a not shown circuit board or the like on which the sensor 1 is mounted and be connected with the sensor element 5 through the circuit board and mounting body 3.

The driving circuit 103 is for example configured including an oscillation circuit or amplifier and supplies an AC voltage having a predetermined frequency between the first excitation electrodes 15A and the second excitation electrodes 15B. The frequency may be determined in advance in the angular velocity sensor 51 or may be designated from an external apparatus or the like.

The detecting circuit 105, for example, is configured including an amplifier or wave detecting circuit, detects a potential difference between the first detecting electrode 17A and the second detecting electrode 17B, and outputs an electrical signal in accordance with the detection result to an external apparatus or the like. More specifically, for example, the potential difference described above is detected as the AC voltage, and the detecting circuit 105 outputs a signal in accordance with the amplitude of the detected AC voltage. The angular velocity is identified based on this amplitude. Further, the detecting circuit 105 outputs a signal in accordance with a phase difference between the applied voltage of the driving circuit 103 and the electrical signal which was detected. The orientation of rotation is identified based on this phase difference.

### (Explanation of Operation of Sensor Element)

As explained above, the group of the first driving arm 23A and second driving arm 23B and the group of the third driving arm 23C and fourth driving arm 23D are excited with inverse phases from each other (phases offset by 180°) so as to deform to inverse sides to each other in the direction of excitation (x-direction).

In this state, if the sensor element 5 rotates about the y-axis, the driving arms 23 receive the Coriolis force in the direction (z-direction) perpendicular to the excitation direction (x-direction) and rotation direction (y-direction). Due to this, the driving arms 23 vibrate in the z-direction. Further, the group of the first driving arm 23A and second driving arm 23B and the group of the third driving arm 23C and fourth driving arm 23D are excited with inverse phases from each other, therefore vibrate so as to flex to inverse sides to each other in the z-direction.

The driving arms 23 and the detecting arms 25 are connected by the base part 21. Accordingly, the vibrations of the driving arms 23 are transferred through the base part 21 to the detecting arms 25, so the detecting arms 25 also vibrate. Specifically, the first detecting arm 25A vibrates so as to flex to the inverse side to the first driving arm 23A and second driving arm 23B in the z-direction. Further, the second detecting arm 25B vibrates so as to flex to the inverse side to the third driving arm 23C and fourth driving arm 23D in the z-direction. From another viewpoint, the first detecting arm 25A and the second detecting arm 25B vibrate so as to flex to inverse sides to each other in the z-direction. Accordingly, as explained in the explanation of the connection relationships of the plurality of detecting electrodes 17, the electrical signals generated in the two detecting arms 25 are added.

In the above description, the explanation was given assuming that the vibrations in the z-direction of the driving arms 23 were transferred to the detecting arms 25. In other words, the explanation was given ignoring the vibrations in the x-direction of the detecting arms 25. In actuality, the action also arises of the vibrations in the x-direction of the driving arms 23 being transferred to the detecting arms 25 and the detecting arms 25 vibrating in the x-direction to generate the Coriolis force in the detecting arms 25, whereby the detecting arms 25 vibrate in the z-direction. In regard to the vibrations in the z-direction of the detecting arms 25, either of these two types of actions may be dominant. In the present embodiment, basically an aspect where the action of transferring the vibrations in the z-direction of the driving arms 23 to the detecting arms 25 is dominant (aspect where the vibrations in the x-direction of the detecting arms 25 are relatively small) will be taken as an example. In such a case, for example, as already referred to, compared with the difference among the natural frequency in the x-direction of the driving arm 23, the natural frequency in the z-direction of the driving arm 23, and the natural frequency in the z-direction of the detecting arm 25, the difference of the natural frequency in the x-direction of the detecting arm 25 relative to the former natural frequencies may be made larger.

### (Electronic Element)

The electronic element 7 shown in FIG. 1 and FIG. 2A may be made suitable one. For example, the electronic element 7 may be made a thermistor or another temperature sensor and/or may be an IC including the driving circuit 103 and detecting circuit 105 explained above. From another viewpoint, the electronic element 7 may be made one which is not connected with the sensor element 5 or may be one which is connected with the sensor element 5. Further, in the example shown, one electronic element 7 is provided. However, a plurality of electronic elements 7 may be provided as well. In the sensor 1, the electronic element 7 also need not be provided.

In the following explanation, basically, an aspect where the electronic element 7 is one which is not electrically connected with the sensor element 5 (for example, a temperature sensor) and the sensor element 5 and the electronic element 7 are electrically connected through the package 11 with an external apparatus independently from each other will be taken as an example.

### (Mounting Body)

The mounting body 3 shown in FIG. 1, FIG. 2A, and FIG. 2B for example has an insulation body 35 which becomes the main part of the mounting body 3, a plurality of (six in the example shown) first pads 37 for mounting the sensor element 5 on the mounting body 3, a plurality of (two in the example shown) second pads 39 for mounting the electronic element 7 on the mounting body 3, and a plurality of (eight in the example shown) external terminals 41 for mounting the sensor 1 on a not shown circuit board or the like.

The insulation body 35 has the recessed part 3a explained above. The outer shape of the insulation body 35 and the shape of the recessed part 3a may be suitably set. In the example shown, the outer shape of the insulation body 35 is formed as a cuboid shape having the x-direction as the long direction.

The shape of the recessed part 3a is substantially a cuboid shape having the x-direction as the long direction in the same way as the insulation body 35. However, the bottom surface of the recessed part 3a, in a region facing the sensor element 5, is further dug down leaving the regions where the first pads 37 are arranged. That is, the bottom surface (facing surface 35b) of the recessed part 3a has a fixed surface 35c to which the sensor element 5 is fixed and a retracting surface 35d which is located at a position lower than the fixed surface 35c and faces the most part of the sensor element 5. Due to this, the sensor element 5 seldom contacts the facing surface 35b. The recessed part 3a may be grasped as having a first recessed part (the portion of the fixed surface 35c) and a second recessed part (portion of the retracting surface 35d) which is formed in the bottom surface of the first recessed part.

The insulation body 35 is, for example, as shown in FIG. 2A and FIG. 2B, configured by a plurality of insulation layers 43 (three insulation layers 43A to 43C in the example shown) stacked on each other. Further, by formation of one or more openings in part of the insulation layers 43 (43A and 43B) on the upper side (+z side), the recessed part 3a is formed.

Each insulation layer 43 is for example configured by a ceramic, resin, or inorganic material in an amorphous state or a combination of the same. In FIG. 2A and FIG. 2B, for convenience, three insulation layers 43 are shown. However, each insulation layer 43 may be configured by a plurality of insulation layers as well. In the sensor 1 after completion, a boundary between the insulation layers need not always be identifiable.

The first pads 37 and second pads 39 are for example configured by conductive layers which are made of metal or another conductor and are superposed on the facing surface 35b (fixed surface 35c) . The materials, planar shapes, and various dimensions of the first pads 37 and second pads 39 may be suitably set. The conductive layer may be configured by a plurality of layers as well.

The sensor element 5 is for example arranged so that the plurality of element terminals 19 face the plurality of first pads 37. Further, the plurality of element terminals 19 and the plurality of first pads 37 are bonded by a plurality of conductive bumps 45 (FIG. 2A and FIG. 2B) interposed between them. Due to this, the sensor element 5 is supported upon the mounting body 3 and is electrically connected to the mounting body 3. The bumps 45 are for example configured by solder (including lead-free solder) or conductive adhesive. The conductive adhesive is for example configured by a conductive filler mixed into a thermosetting resin.

As apparent from the above explanation, the number and arrangement positions of the plurality of first pads 37 correspond to the number and arrangement positions of the plurality of element terminals 19. The shapes and sizes of the first pads 37 may be the same as or different from the shapes and sizes of the element terminals 19. Further, the electronic element 7, for example, in the same way as the sensor element 5, is bonded through bumps (notation is omitted) with the second pads 39.

The external terminals 41 are for example configured by conductor layers which are made of metal or another conductor and are superposed on the lower surface of the insulation body 35. The materials, planar shapes, and various dimensions of the external terminals 41 may be suitably set. The conductive layer may be configured by a plurality of layers as well. Further, the number and positions of the plurality of external terminals 41 may be suitably set in accordance with the configurations of the sensor element 5 and electronic element 7 and the like. In the example shown, eight external terminals 41 are arranged along the outer edge of the lower surface of the insulation body 35.

Among the plurality of external terminals 41, four external terminals 41 are connected independently from each other through wiring conductors (notation is omitted) provided on the surface or in the internal portion of the insulation body 35 with respect to the four first pads 37. These four first pads 37 are connected independently from each other through the four element terminals 19 to the two sets of excitation electrodes 15 and two sets of detecting electrodes 17. Further, the remaining four external terminals 41 are connected through wiring conductors (notation is omitted) provided on the surface or in the internal portion of the insulation body 35 to the two first pads 37 to be given the reference potential and to the second pads 37 for the electronic element 7.

### (Lid)

The lid 9 is for example configured by metal. The lid 9 is bonded to the upper surface of the mounting body 3 by seam welding or the like. Due to this, the interior of the recessed part 3a is air tightly sealed. The air tightly sealed interior of the recessed part 3a is for example evacuated or sealed with a suitable gas (for example nitrogen). Illustration of the conductive layers (notation is omitted) shown in FIG. 2A and FIG. 2B which contribute to bonding of the lid 9 is omitted in FIG. 1.

### (Mounting of Sensor)

The above sensor 1 is for example arranged on the mounting surface of a not shown circuit board so that the lower surface of the mounting body 3 is made to face the mounting surface and is mounted on the circuit board by bonding of the external terminals 41 to the pads on the circuit board by solder or the like. On the circuit board, for example, the already explained driving circuit 103 and detecting circuit 105 are configured.

As explained above, the sensor element 5 in the present embodiment has the piezoelectric body 13, the plurality of first electrodes (excitation electrodes 15) and plurality of second electrodes (detecting electrodes 17), and the plurality of element terminals 19 which are connected to the plurality of excitation electrodes 15 and plurality of detecting electrodes 17. The piezoelectric body 13 has the base part 21, a pair of first arms (first driving arm 23A and fourth driving arm 23D or second driving arm 23B and third driving arm 23C), a pair of second arms (detecting arms 25), the holding part 29, and the mounting part 31. The pair of driving arms 23 extend alongside each other from the base part 21 to one side (+y side) in the y-direction and have the plurality of excitation electrodes 15 positioned on them. The pair of detecting arms 25 extend alongside each other from the base part 21 to the other side (-y side) in the y-direction and have the plurality of detecting electrodes 17 positioned on them. The holding part 29 extends between the pair of detecting arms 25 from the base part 21 to the -y side and extends out beyond the front ends of the pair of detecting arms 25 to the -y side. The mounting part 31 is connected to the end part of the holding part 29 on the -y side and has the plurality of element terminals 19 positioned on it. Further, the mounting part 31 has a first extending portion (detection side extending portion 31a) and a pair of second extending portions (lateral side extending portions 31b). The detection side extending portion 31a extends from the position where it is connected with the holding part 29 to the x-side and -x side. The pair of lateral side extending portions 31b extend toward the +y side from the positions on the +x side and -x side other than the two of the pair of detecting arms 25. At least one (all in the present embodiment) of the plurality of element terminals 19 is positioned beyond the detection side extending portion 31a on the further +y side.

Accordingly, first, by the holding part 29 holding the base part 21, the possibility of transfer of stress in the mounting part 31 to the base part 21 can be reduced. Further, the mounting part 31 has the detection side extending portion 31a and pair of lateral side extending portions 31b. Therefore, for example, compared with a case where the mounting part is flat plate shaped so as to be connected to the end part in the holding part 29 on the -y side, the necessity of securing a region where the element terminals 19 are arranged on the -y side is reduced, so the size can be reduced on the -y side. Further, the plurality of element terminals 19 are easily arranged dispersed on the -y side and +y side, therefore the sensor element 5 is easily mounted in parallel with respect to the facing surface 35b. As a result, for example, the size is reduced while the accuracy of detection of the sensor 1 can be improved.

Further, in the present embodiment, the pair of lateral side extending portions 31b extend beyond the front ends of the pair of detection arms 25 toward the further +y side. At least one (all in the present embodiment) of the plurality of element terminals 19 is positioned beyond the front ends of the pair of detection arms 25 on the further +y side.

In this case, it becomes easier to secure the region where the element terminals 19 are arranged beyond the detection side extending portion 31a on the further +y side. Therefore, for example, the effect of reducing the size on -y side while arranging the plurality of element terminals 19 dispersed is improved.

Further, in the present embodiment, in the piezoelectric body 13, the mounting part 31 and the base part 21 are connected by only the holding part 29. All of the plurality of element terminals 19 are positioned beyond than the detection side extending portion 31a on the further +y side.

Therefore, for example, the distance from the base part 21 up to the nearby element terminal 19 through the holding part 29 becomes long. As a result, for example, support of the base part 21 by the support part 27 easily becomes elastic. In turn, even if force is applied to the element terminal 19 due to a difference of thermal expansions of the sensor element 5 and the mounting body 3, the possibility of transfer of this force to the base part 21 is reduced.

Further, in the present embodiment, the pair of lateral side extending portions 31b extend out beyond the front ends of the pair of driving arms 23 toward the further +y side. The mounting part 31 further has a third extending portion (driving side extending portion 31c) which bridges the portions in the pair of lateral side extending portions 31b beyond the front ends of the pair of driving arms 23 on the further +y side.

Accordingly, for example, deformations of the pair of lateral side extending portions 31b relative to each other are restricted by the driving side extending portion 31c. As a result, for example, a change of posture of the base part 21 with respect to the mounting part 31 is suppressed. Further, vibrations of the lateral side extending portions 31b due to the excitation of the driving arms 23 are reduced. As a result, the detection accuracy of the angular velocity is improved.

In the first embodiment, the excitation electrodes 15 are one example of the first electrodes. The detecting electrodes 17 are one example of the second electrodes. The driving arms 23 are one example of the first arms. The detecting arms 25 are one example of the second arms. The detection side extending portion 31a is one example of the first extending portion. The lateral side extending portions 31b are one example of the second extending portion. The driving side extending portion 31c is one example of the third extending portion. In the mounting part 31, the positions where the plurality of element terminals 19 are arranged are one example of the plurality of fixation positions.

### [Second Embodiment]

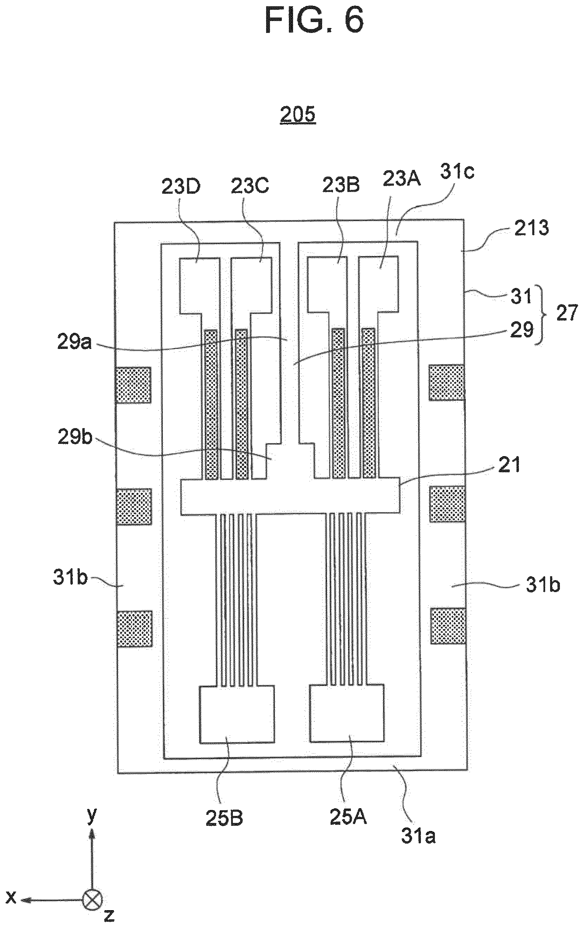

FIG. 6 is a plan view showing a sensor element 205 according to a second embodiment and corresponds to FIG. 4 of the first embodiment.

In the sensor element 5 according to the first embodiment, the holding part 29 extended alongside the detecting arms 25 from the base part 21 and was connected to the mounting part 31. Contrary to this, in the sensor element 205 (piezoelectric body 213) according to the present embodiment, the holding part 29 extends alongside the driving arms 23 from the base part 21 and is connected to the mounting part 31. In this way, the holding part 29 may be provided not on the detecting arm 25 side, but on the driving arm 23 side.

However, in the first and second embodiments, the driving arms 23 are excited in the x-direction and the detecting arms 25 vibrate in the z-direction due to the Coriolis force. Therefore, a clearance between the holding part 29 and the detecting arm 25 in the first embodiment can be made smaller than the clearance between the holding part 29 and the driving arm 23 in the second embodiment. Consequently, in the first embodiment, the width (x-direction) and/or length (y-direction) of the connection portion 29b is more easily made larger than that in the second embodiment.

In the second embodiment, the excitation electrodes 15 are one example of the second electrodes. The detecting electrodes 17 are one example of the first electrodes. The driving arms 23 are one example of the second arms. The detecting arms 25 are one example of the first arms. The detection side extending portion 31a is one example of the third extending portion. The driving side extending portion 31c is one example of the first extending portion.

### [Third Embodiment]

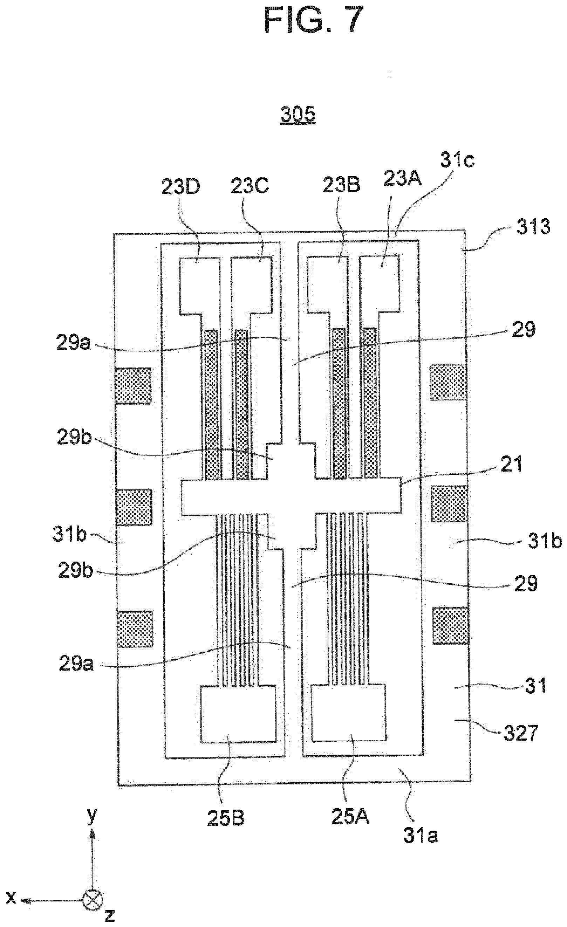

FIG. 7 is a plan view showing a sensor element 305 according to a third embodiment and corresponds to FIG. 4 of the first embodiment.

In the sensor element 5 according to the first embodiment, only one holding part 29 was provided. On the other hand, in the sensor element 305 (piezoelectric body 313, support part 327) according to the present embodiment, two holding parts 29 are provided. More specifically, provision is made of a holding part 29 which extends alongside the detecting arms 25 from the base part 21 and of a holding part 29 which extends alongside the driving arms 23 from the base part 21. That is, in the present embodiment, the first and second embodiments are combined.

In the present embodiment, the base part 21 is supported by the two holding parts 29, so, for example, when shock is applied to the sensor element 5, the force which is added from the base part 21 to the holding part 29 is dispersed to the two holding parts 29. As a result, the possibility of breakage of the holding part 29 is reduced more than that in the first and second embodiments.

In the first and second embodiments, the effect is exerted that, compared with the third embodiment, for example, the stress of the mounting part 31 causes just displacement of the base part 21 and is not easily transferred to the internal portion of the base part 21. However, in the third embodiment as well, compared with an aspect where the two ends of the base part 21 are connected to the mounting part 31, the base part 21 is connected to the holding parts 29 only at the center, therefore the stress in the mounting part 31 is not easily transferred to the internal portion of the base part 21.

### [Fourth Embodiment]

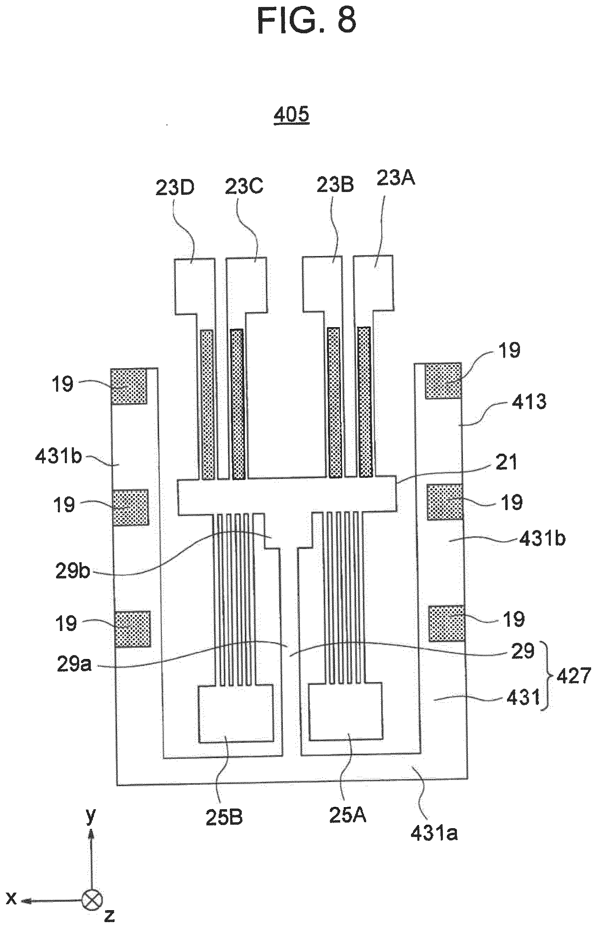

FIG. 8 is a plan view showing a sensor element 405 according to a fourth embodiment and corresponds to FIG. 4 of the first embodiment.

In the sensor element 5 according to the first embodiment, the shape of the mounting part 31 was made an annular shape (specifically, rectangular). On the other hand, in the sensor element 405 (piezoelectric body 413, support part 427) according to the present embodiment, a mounting part 431 is not made annular.

Specifically, the mounting part 431 is shaped with a portion, which is on the side where the driving arms 23 extend (opposite side to the holding part 29, +y side), removed from the mounting part 31 according to the first embodiment. In other words, the mounting part 431 for example has a detection side extending portion 431a the same as that in the first embodiment and a pair of lateral side extending portions 431b which are obtained by removing single portions on the +y side from the pair of lateral side extending portions 31b in the first embodiment, and does not have the driving side extending portion 31c of the first embodiment. As a result, the mounting part 431 is broken at the end parts on the +y side of the pair of lateral side extending portions 431b. In other words, the end parts on the +y side of the pair of lateral side extending portions 431b configure the two ends of the mounting part 431.

The positions in the y-direction of the end parts on the +y side of the lateral side extending portions 431b (from another viewpoint, the lengths of the lateral side extending portions 431b) may be suitably set. In the example shown, the end parts are for example positioned closer to the -y side than the front ends of the driving arms 23 in the y-direction. In more detail, for example, the end parts are positioned between the front ends of the driving arms 23 and the base part 21. However, unlike the example shown, the end parts in the y-direction may be positioned at positions equal to that of the base part 21 or at positions closer to the detection side extending portion 431a than the base part 21. The element terminals 19 on the +y most side are for example positioned in the above end parts of the lateral side extending portions 431b.

In such a configuration, for example, compared with the first to third embodiments, the sensor element 405 can be reduced in size on the +y side. In the first to third embodiments, compared with the fourth embodiment, for example, deformations of the pair of lateral side extending portions 31b relative to each other are restricted by the driving side extending portion 31c. As a result, for example, it is expected that change of posture of the base part 21 with respect to the mounting part 31 is suppressed, so the accuracy of detection of the angular velocity is improved.

### [Fifth Embodiment]

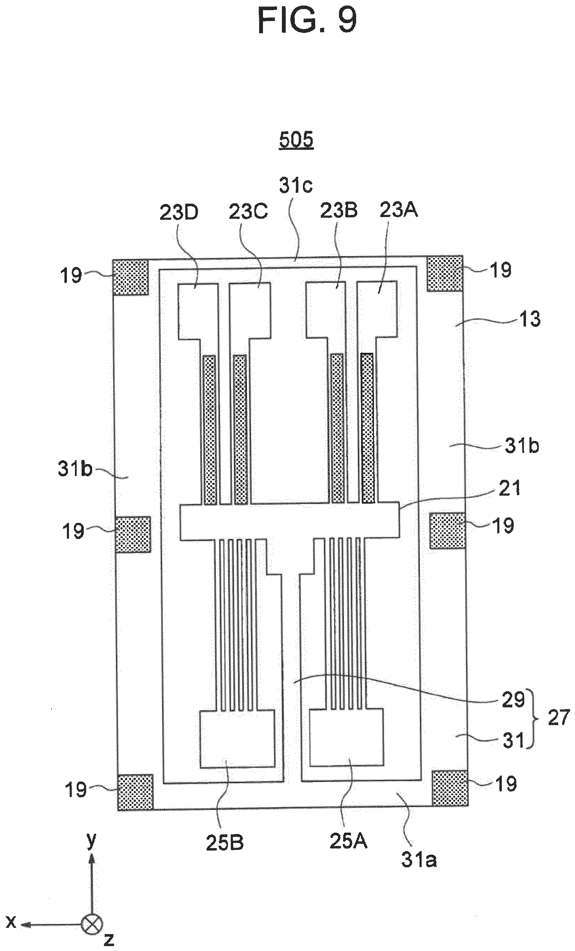

FIG. 9 is a plan view showing a sensor element 505 according to a fifth embodiment and corresponds to FIG. 4 of the first embodiment.

In the sensor element 5 according to the first embodiment, the element terminals 19 were arranged separated from the four corners of the rectangular frame shaped mounting part 31. From another viewpoint, all element terminals 19 were arranged beyond the detection side extending portion 31a on the further +y side. On the other hand, in the sensor element 505 according to the present embodiment, the plurality of element terminals 19 include four element terminals 19 which are positioned at the four corners of the mounting part 31. From another viewpoint, part of the element terminals 19 are not positioned beyond the detection side extending portion 31a on the further +y side.

Even in such a configuration, at least one of the plurality of element terminals 19 is positioned beyond the detection side extending portion 31a on the further +y side. Therefore, for example, the necessity of securing a region where the element terminals 19 are arranged on the -y side is reduced, therefore the size on the -y side can be reduced.

The sensor element and angular velocity sensor according to the present disclosure are not limited to the above embodiments and modifications and may be worked in various embodiments.

The embodiments and modifications explained above may be suitably combined. For example, the arrangement of the holding part in the second embodiment and the shape of the mounting part in the fourth embodiment may be combined. In this case, the mounting part, conversely to the fourth embodiment, may be shaped broken on the detecting arm side (-y side) . Further, for example, the arrangement of the holding part in the second to third embodiments and the arrangement of the element terminals in the fifth embodiment may be combined.

The vibration modes of the driving arms and detecting arms are not limited to those illustrated in the embodiments. Further, the axis of the angular velocity which is detected is not limited to the y-axis. For example, conversely to the embodiments, the driving arms may be made to vibrate to inverse sides to each other in the z-direction, and the rotation about the y-axis may be detected by vibrations of the detecting arms to inverse sides to each other in the x-direction. Between this mode and the embodiments, the configurations and connections of the excitation electrodes and the configurations and connections of the detecting electrodes become inverse. Further, for example, provision may be made of a pair of driving arms which extend from the base part to the +y side, a pair of driving arms which extend from the base part to the -y side, a detecting arm which extends between the pair of driving arms on the +y side from the base part to the +y side, and a holding part which extends between the pair of driving arms on the -y side from the base part to the -y side, the driving arms may be made to vibrate in the x-direction, the base part may be made to vibrate in the rotation direction with respect to the position of connection with the holding part due to the Coriolis force in the y-direction which is generated by the rotation about the z-axis, thereby the detecting arm may be made to vibrate in the x-direction.

Further, the driving arms may be made not two pairs, but one pair or may be made three or more pairs. Further, the detecting arms may be made not one pair, but two or more pairs.

The shape of the holding part is not limited to the one illustrated in the embodiments. For example, the connection part (portion having a broad width) need not be provided. The main part need not extend with a constant width over its entirety. For example, the main part may be shaped so as to gradually become broader in width toward the base part (21) in part or whole. Further, the holding part may become broader in width in the portion where it extends out beyond the front ends of the pair of second arms and is connected to the mounting part (for example 31) than the width of the portion positioned between the front ends of the pair of second arms. Further, for example, the connection portion may be shaped other than rectangular (for example trapezoidal shaped) as well. In the embodiments, in the length of the holding part from the base part up to the front ends of the second arms, a ratio of occupation by the main part was made longer than the ratio of occupation by the connection part. However, the ratio of occupation by the connection part may be made longer than the ratio of occupation by the main part as well.

Also the shape of the mounting part is not limited to the one illustrated in the embodiments. For example, the extending portion need not linearly extend with a constant width, but may flex in a portion or become narrower in width in a portion.

The sensor element or angular velocity sensor may be configured as a portion of an MEMS (micro electromechanical system) . In this case, for example, the piezoelectric body configuring the sensor element may be mounted on the substrate of the MEMS.

### Reference Signs List

1... angular velocity sensor, 5... sensor element, 13... piezoelectric body, 15... excitation electrode (first electrode), 17... excitation electrode (second electrode), 19... element terminal (terminal), 21... base part, 23... driving arm (first arm), 25... detecting arm (second arm), 29... holding part, 31... mounting part, 31a... detection side extending portion (first extending portion), and 31b... lateral side extending portion (second extending portion).

## Claims

1. A sensor element comprising:
a piezoelectric body,
a plurality of first electrodes and a plurality of second electrodes, and
a plurality of terminals each connected to any of the plurality of first electrodes and the plurality of second electrodes, wherein
the piezoelectric body, when viewed in a z-direction in an orthogonal coordinate system xyz, comprises
a base part,
two first arms which extend alongside each other from the base part toward one side in a y-direction and on which the plurality of first electrodes are located,
two second arms which extend alongside each other from the base part toward the other side in the y-direction and on which the plurality of second electrodes are located,
a holding part which extends between the two second arms from the base part toward the other side in the y-direction and extends out beyond front ends of the two second arms toward the other side in the y-direction, and
a mounting part which is connected to an end part of the holding part on the other side in the y-direction and on which the plurality of terminals are located,
the mounting part comprises
a first extending portion which extends from a position connected with the holding part toward an x-side and -x side, and
two second extending portions which extend from positions in the first extending portion which are beyond both of the two second arms on the further +x side and -x side toward the one side in the y-direction, and
at least one of the plurality of terminals is located beyond the first extending portion on the one side in the y-direction.

2. The sensor element according to claim 1, wherein:
the two second extending portions extend beyond the front ends of the two second arms toward the one side in the y-direction, and
at least one of the plurality of terminals is located beyond the front ends of the two second arms on the one side in the y-direction.

3. The sensor element according to claim 1 or 2, wherein:
in the piezoelectric body, the mounting part and the base part are connected through the holding part, and
all of the plurality of terminals are located beyond the first extending portion on the further one side in the y-direction.

4. The sensor element according to any one of claims 1 to 3, wherein
the two second extending portions extend out beyond front ends of the two first arms toward the one side in the y-direction, and
the mounting part further comprises a third extending portion which bridges between portions in the two second extending portions beyond the front ends of the two first arms on the one side in the y-direction.

5. The sensor element according to any one of claims 1 to 3, wherein end parts of the two second extending portions on the one side in the y-direction configure two ends of the mounting part and are located beyond front ends of the two first arms on the other side in the y-direction.

6. An angular velocity sensor comprising:
a sensor element including a piezoelectric body, and
a mounting body on which the sensor element is mounted, wherein
the piezoelectric body, when viewed in a z-direction in an orthogonal coordinate system xyz, comprises
a base part,
two first arms which extend alongside each other from the base part toward one side in a y-direction,
two second arms which extend alongside each other from the base part toward the other side in the y-direction,
a holding part which extends between the two second arms from the base part toward the other side in the y-direction and extends out beyond front ends of the two second arms toward the other side in the y-direction, and
a mounting part which is connected to an end part of the holding part on the other side in the y-direction and is fixed to the mounting body at a plurality of fixation positions, and
the mounting part comprises
a first extending portion which extends from a position connected with the holding part toward a +x side and -x side, and
two second extending portions which extend from positions in the first extending portion which are beyond both of the two second arms on the further +x side and -x side toward the one side in the y-direction, and
at least one of the plurality of fixation positions is located beyond the first extending portion on the one side in the y-direction.
